# DEMANDE DE BREVET EUROPEEN

(11) **EP 2 339 640 A1**
(43) Date de publication de la demande: **29.06.2011**
(21) Numéro de dépôt: 10306309.5
(22) Date de dépôt: 29.11.2010
(51) Int. Cl.: H01L 31/02, H01L 31/103

(54) **Photodétecteur à structure plasmon**

(30) Priorité: 24.12.2009 FR 0959569
(71) Demandeur: Commissariat à l'Énergie Atomique et aux Énergies Alternatives, 75015 Paris (FR)
(72) Inventeur: Gravrand, Olivier, 38120, FONTANIL-CORNILLON (FR); Destefanis, Gérard, 38120, SAINT EGREVE (FR); Le Perchec, Jérôme, 38000, GRENOBLE (FR)
(74) Mandataire: Vuillermoz, Bruno

(57) **Abrégé**

Ce photodétecteur comprend :
■ une couche semiconductrice dopée (12);
■ une couche réflectrice (22), agencée sous la couche semiconductrice (12);
■ une structure métallique (16), agencée sur la couche semiconductrice (12), et formant avec la couche semiconductrice (12) un résonateur par excitation d'un mode plasmon de surface,
■ une pluralité de zones semiconductrices (24), formées dans la couche semiconductrice (12) et présentant un dopage opposé au dopage de celle-ci ; et
■ pour chaque zone semiconductrice (24), un conducteur (26) traversant le photodétecteur depuis la couche réflectrice (22) jusqu'au moins la zone semiconductrice (24), et isolé électriquement de la structure métallique (16), la zone semiconductrice (24) associée au conducteur (26) correspondant déterminant ainsi une surface élémentaire de détection du photodétecteur.

## Description

### DOMAINE DE L'INVENTION

La présente invention a trait au domaine de la détection de rayonnement électromagnétique, et notamment infrarouge, à l'aide de structures métalliques dites «structures plasmon ».

### ETAT DE LA TECHNIQUE

Un mode de détection connu d'un rayonnement infrarouge consiste à réaliser l'absorption de ce rayonnement par une couche de matériau semi-conducteur à petit gap, comme par exemple du CdHgTe. L'absorption des photons par cette couche crée alors des paires électron-trou et les porteurs minoritaires ainsi produits diffusent ou dérivent sous l'effet d'un champ électrique dans la couche d'absorption pour être collectés au niveau d'électrodes. La qualité de la détection est alors principalement dictée par les dimensions de la couche d'absorption.

En effet, le rendement quantique de la détection est d'autant meilleur que cette couche est épaisse. Dans le même temps, le courant d'obscurité, qui constitue l'une des principales sources de bruit dans ce type de détection, est quant à lui d'autant plus élevé que le volume de collection des photo-porteurs est important. Ainsi, la conception d'une telle détection relève du compromis entre l'efficacité de la détection, défini par le rendement quantique, et la quantité de bruit présent dans le signal issu de la détection, pour partie induit par le courant d'obscurité.

Pour pallier ce problème, des photodétecteurs du type métal-semi-conducteur-métal avec des structures métalliques, dites structures « plasmon », disposées sur ou dans la couche d'absorption ont été conçus. De cette manière, un couplage est obtenu pour le rayonnement électromagnétique incident avec des plasmons de surface. Un choix approprié desdites structures, prenant usuellement la forme de poutres rectilignes et parallèles à section rectangulaire, permet alors un confinement très important du champ électromagnétique dans la couche d'absorption, induisant ainsi une réduction importante du courant d'obscurité.

Outre le confinement du champ électromagnétique dans un volume restreint, les structures plasmon permettent également, sous certaines conditions géométriques, de diminuer le temps de réponse du détecteur, qui est lié à la vitesse de diffusion des porteurs dans la couche d'absorption, ou d'appliquer un filtrage spectral ou une sélectivité de polarisation. On pourra par exemple se référer au document WO 01/2275 pour plus de détails.

Toutefois, dans ce type de photodétecteurs, la collecte des porteurs de charge est réalisée via les structures métalliques elle-même, c'est-à-dire du côté incident du rayonnement. Ainsi, un photodétecteur de ce type constitue un unique élément de détection, détecteur « unitaire » ou encore une barrette linéaire de petite taille. Pour obtenir un photodétecteur bidimensionnel ayant une pluralité d'éléments unitaires de détection, ou pixels, il est alors nécessaire de reporter sur un même support une pluralité de photodétecteurs unitaires indépendants les uns des autres, ce qui s'avère coûteux, voir impossible. Une technique classique permettant l'exploitation d'un grand nombre d'éléments simultanément est l'hybridation des photodétecteurs sur un circuit de lecture en silicium via la technique dite de « flip-chip » utilisant une interconnexion par billes de soudure en indium d'une matrice bidimensionnelle de connecteurs. Malheureusement, dans cette configuration, les électrodes font face au circuit de lecture et non à la face incidente du rayonnement, ce qui rend la structure plasmon inefficace.

### EXPOSE DE L'INVENTION

Le but de la présente invention est de résoudre le problème susmentionné en proposant un photodétecteur permettant une détection bidimensionnelle à partir d'un unique agencement de structure plasmon et de couche semiconductrice absorbante.

A cet effet, l'invention a pour objet un photodétecteur comprenant :
■ une couche semiconductrice dopée ;
■ une couche réflectrice agencée sous la couche semiconductrice ; et
■ une structure métallique agencée sur la couche semiconductrice, et formant avec la couche semiconductrice un résonateur par excitation d'un mode plasmon de surface.

Selon l'invention, le photodétecteur comprend en outre :
■une pluralité de zones semiconductrices, formées dans la couche semiconductrice et présentant un dopage opposé au dopage de celle-ci ; et
■ pour chacune desdites zones semiconductrices, un conducteur traversant le photodétecteur depuis la couche réflectrice jusqu'au moins la zone semiconductrice et isolé électriquement de la structure métallique, la zone semiconductrice, associée au conducteur correspondant, déterminant ainsi une surface élémentaire de détection du photodétecteur.

En d'autres termes, les zones semiconductrices formées dans la couche d'absorption, en association avec les conducteurs, forment des zones de collecte des porteurs de charge crées dans ladite couche. La structure métallique joue donc uniquement un rôle optique et n'est pas utilisée pour la collecte des porteurs de charge. Chaque zone semiconductrice collecte les porteurs dans son voisinage immédiat, définissant donc un élément unitaire de détection. En formant un réseau de zones semiconductrices, il est ainsi obtenu une pluralité d'éléments unitaires de détection, et donc une détection bidimensionnelle, et cela sans fabrication d'éléments unitaires distincts ensuite reportés sur un support. Notamment, les structures métalliques dites structures plasmon peuvent être continues sur toute la surface du photodétecteur.

Selon des modes de réalisation particuliers de l'invention, le photodétecteur peut comporter un ou plusieurs des caractéristiques suivantes.

Le photodétecteur comporte une couche d'accord diélectrique, formée entre la couche réflectrice et la couche semi-conductrice. Cette couche d'accord permet de régler la fréquence optique à laquelle le rayonnement détecté entre en résonance avec la géométrie de la structure métallique. Ainsi, la géométrie des structures plasmons, mais aussi l'épaisseur de cette couche diélectrique participent toutes deux au dimensionnement du photodétecteur, notamment concernant la gamme spectrale de sensibilité.

Le photodétecteur comporte une couche de passivation isolante entre la couche semiconductrice et la structure métallique. Cette couche isolante permet d'isoler électriquement efficacement les conducteurs de la structure métallique et d'empêcher ainsi des connexions électriques entre la couche semiconductrice et les zones semiconductrices caractéristiques de l'invention par l'intermédiaire de la structure métallique.

La zone semiconductrice est sensiblement formée au barycentre géométrique de la partie de la structure métallique comprise dans la surface élémentaire de détection. En plaçant ainsi la zone semiconductrice, le barycentre du spectre du rayonnement détecté est conservé, et cela quelle que soit la géométrie de la structure métallique.

La partie de la structure métallique comprise dans la surface élémentaire de détection comporte des zones de motifs parallèles et d'orientations différentes, notamment des zones de motifs d'orientations sensiblement perpendiculaires. Grâce à des motifs d'orientations différentes, il est ainsi possible de détecter plusieurs polarisations du rayonnement électromagnétique incident.

La partie de structure métallique comprise dans la surface élémentaire de détection comporte des éléments longilignes formant des contours fermés concentriques, notamment des contours sensiblement de forme carrée ou circulaire. Le photodétecteur est ainsi non sélectif en polarisation. D'autres structures plasmon peuvent être utilisées pour obtenir une non sélectivité en polarisation, comme par exemple un réseau de patch métalliques, tel que par exemple décrit dans la publication de J. Le Perchec et al., "Plasmon-based photosensors comprising a very thin semiconducting region", Appl. Phys. Lett. 94, 181104 (2009)], ou encore un réseau de trous formés dans un film métallique.

La partie de structure métallique comprise dans une surface élémentaire de détection comporte des motifs parallèles, l'orientation des motifs d'une surface élémentaire de détection étant différente de l'orientation des motifs d'une surface de détection adjacente, et notamment perpendiculaire. Il est ainsi obtenu des pixels adjacents qui ne sont pas sensibles aux mêmes polarisations. Il est alors possible de combiner les signaux issus de pixels adjacents afin d'obtenir une détection du rayonnement selon plusieurs directions de polarisation.

La partie de structure métallique comprise dans une surface élémentaire de détection comporte des motifs parallèles, la périodicité spatiale des motifs d'une surface élémentaire de détection étant différente de la périodicité spatiale des motifs d'une zone élémentaire de détection adjacente. De cette manière, des pixels adjacents ne sont pas sensibles à la même longueur d'onde. Il devient alors possible de combiner les signaux issus de pixels adjacents afin d'obtenir une détection du rayonnement non sélective en longueur d'onde, tout en conservant le confinement de champ électromagnétique dans la couche semiconductrice.

Dans un mode de réalisation, les zones élémentaires de détection sont regroupées en macropixels, les zones semiconductrices de chaque macropixel étant aptes à être connectées électriquement en parallèle.

Plus particulièrement, les surfaces élémentaires de détection d'un macropixel comportent des zones de motifs parallèles d'orientations différentes, notamment des zones de motifs d'orientations sensiblement perpendiculaires les unes par rapport aux autres. En variante, les surfaces élémentaires de détection d'un macropixel comportent des motifs parallèles, l'orientation des motifs d'une surface élémentaire de détection étant différente de l'orientation des motifs d'une surface de détection adjacente, et notamment perpendiculaire.

Le conducteur comporte, du côté de la couche réflectrice, une surface de reprise de contact pour l'hybridation du photodétecteur sur un circuit électronique. De cette manière, le photodétecteur peut être reporté par exemple sur un circuit de lecture classique. La couche réflectrice et la surface de reprise de contact peuvent ne former qu'une seule et même couche.

La couche semiconductrice et les zones semiconductrices sont constituées de CdZnTe ou de CdHgTe.

### BREVE DESCRIPTION DES FIGURES

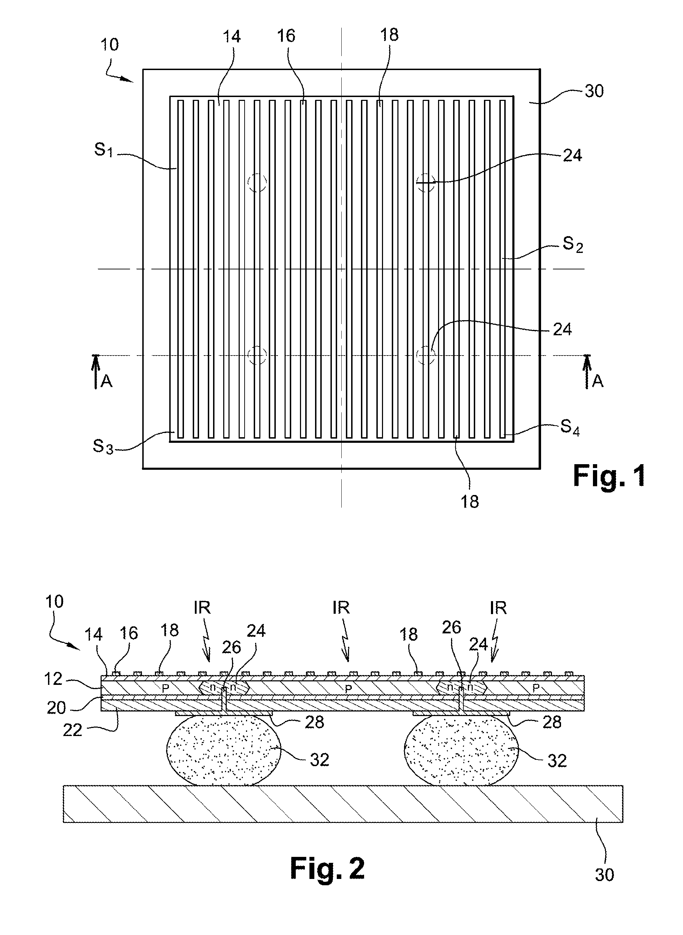

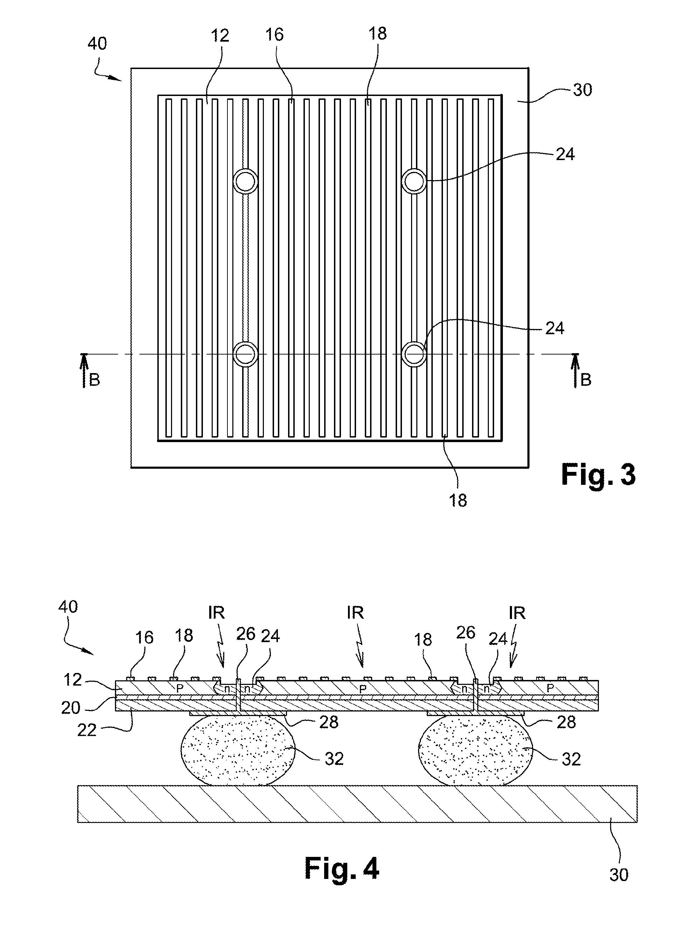

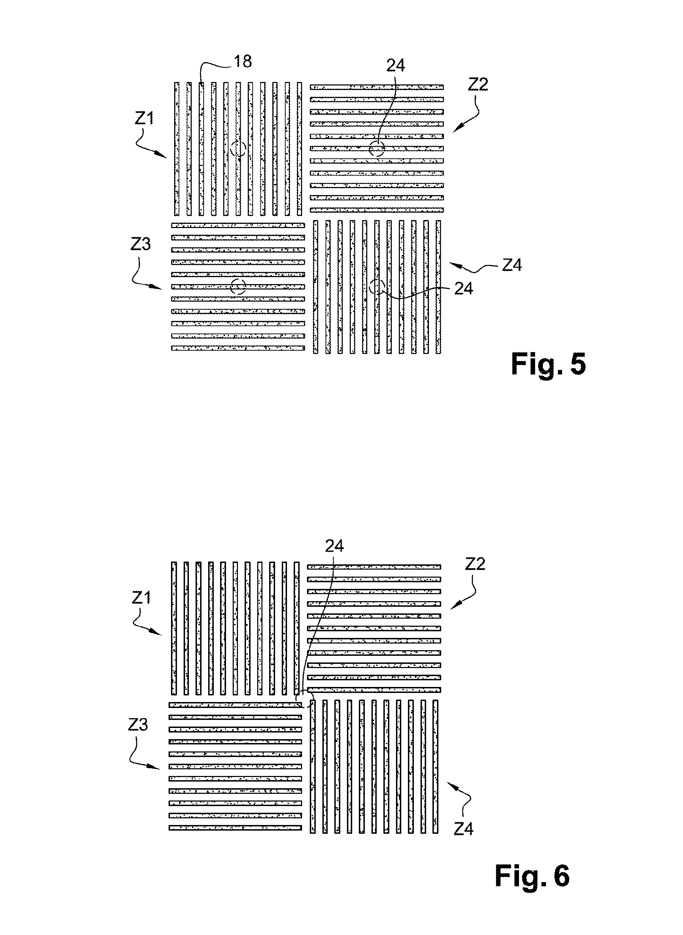

La présente invention sera mieux comprise à la lecture de la description qui suit, donnée uniquement à titre d'exemple, et réalisée en relation avec les dessins annexés, dans lesquels des références identiques désignent des éléments identiques ou analogue, et dans lesquels :
■ la figure 1 est une vue schématique de dessus d'un photodétecteur selon l'invention ;
■ la figure 2 est une vue en section du photodétecteur de la figure 1, selon l'axe A-A ;
■ les figures 3 et 4 sont des vues schématiques respectivement de dessus et en section d'un deuxième mode de réalisation de l'invention ; et
■ les figures 5 à 8 sont des vues schématiques de dessus de plusieurs géométries de structure plasmon selon l'invention.

### DESCRIPTION DETAILLEE DE L'INVENTION

Un photodétecteur bidimensionnel selon l'invention est illustré au sein des figures 1 et 2 sous la référence générale 10. Dans cet exemple, un photodétecteur de 2 x 2 pixels est représenté.

Le photodétecteur **10** comporte :
■ une couche semiconductrice absorbante **12** de quelques centaines de nanomètres d'épaisseur, dans laquelle les photons incidents créent des paires électron-trou ; il s'agit par exemple d'une couche semi-conductrice dopée p réalisée en CdHgTe ou en CdZnTe pour la détection d'un rayonnement infrarouge moyen (longueur d'onde comprise entre 3 et 5 micromètres) et/ou lointain (longueur d'onde comprise entre 8 et 10 micromètres) ;
■ une couche isolante de passivation **14**, déposée sur la couche semiconductrice **12** et de quelques dizaines de nanomètres d'épaisseur ;
■ une structure métallique **16**, par exemple réalisée en or, formée de poutrelles **18** métalliques identiques, rectilignes, parallèles et de section transversale rectangulaire. La structure **16** forme avec la couche semiconductrice **12** un résonateur par excitation d'un mode plasmon de surface, comme cela est connu en soi dans l'état de la technique ;
■ une couche diélectrique d'accord **20**, de quelques dizaines de nanomètres d'épaisseur, déposée sous la couche semiconductrice **12**, par exemple une couche réalisée en CdTe ; et
■ une couche réflectrice **22**, par exemple un réseau de Bragg ou une couche métallique réfléchissante, déposée sous la couche d'accord **20**.

Le photodétecteur comporte en outre une pluralité de zones semiconductrices **24** formées dans la couche semiconductrice **12** et présentant un dopage différent de celle-ci, par exemple des zones en CdHgTe ou en CdZnTe avec un dopage n.

Un via métallique **26** formant conducteur, par exemple réalisé en platine, est par ailleurs formé pour chaque zone semiconductrice **24**. Le via **26** s'étend depuis la couche réflectrice **22** jusqu'au moins la zone **24** et est électriquement isolé de la structure métallique **16**, par exemple en ne traversant pas totalement la couche absorbante **12**, et par la présence de la couche de passivation isolante **14**. Il n'existe donc pas de chemin électrique entre la couche semiconductrice **12** et les zones semiconductrices **24** passant par la structure métallique **16**. On notera que l'épaisseur de la couche de passivation **14** peut être réduite, notamment pour optimiser le couplage entre la structure métallique **16** et la couche semiconductrice **12**. Dans certaines configurations, cette couche de passivation **14** peut même être omise, la structure métallique **16** étant alors formée directement sur la couche semiconductrice **12**. L'isolation électrique des via **26** est alors obtenue du fait que ceux-ci ne traversent pas complètement la couche **12**.

De manière optionnelle, des reprises de contact métalliques **28** sont par ailleurs formées dans le prolongement des via **26** pour l'hybridation du photodétecteur **10** sur un circuit de lecture **30** au moyen de billes de soudure **32** par exemple en indium.

Avantageusement, les dimensions et l'espacement des poutrelles **18** de la structure métallique **16** sont sélectionnés pour que le champ électromagnétique issu d'un rayonnement électromagnétique incident sur la face avant du photodétecteur, c'est-à-dire la face pourvue de la structure **16**, soit confiné dans la couche absorbante **12** entre les poutrelles **18** et sur une faible épaisseur, notamment une épaisseur comprise entre 200 et 500 nanomètres.

Les structures plasmon sont classiques et ne seront donc pas décrites plus en détail par la suite pour des raisons de concision. Pour plus de détails sur le fonctionnement d'une structure plasmon, on pourra par exemple se référer au document WO 01/2275.

Dans le cas où le champ électromagnétique est confiné entre les poutrelles **18**, chaque zone semiconductrice **24** est alors avantageusement placée sous une poutrelle **18** faisant ainsi coïncider le volume de collecte du photocourant et du courant d'obscurité et optimisant ainsi la structure.

Par ailleurs, la couche d'accord **20**, et plus particulièrement son épaisseur, peut permettre de choisir la fréquence du rayonnement incidente qui entre en résonance avec les plasmons de surface de la structure métallique 16**.** On pourra se référer pour plus de précision au document « Résonances photoniques dans les réseaux métalliques ; théorie et application à la photodétection ultrarapide », de Stéphane Collin, Thèse, Univ. Paris 6,2002

On notera que la couche d'accord **20** est facultative, dépendant de la géométrie précise des structures plasmon utilisées [cf Article Jérome Le Perchec, "Plasmon-based photosensors comprising a very thin semiconducting region ", Appl. Phys. Lett. 94, 181104 (2009)]. On notera également que dans le cas où la couche réflectrice **22** est métallique, la couche d'accord **20** peux ne pas jouer de rôle optique mais devient de ce fait une couche de passivation isolante d'épaisseur réduite.

En fonctionnement, la face avant du photodétecteur **10**, c'est-à-dire celle pourvue de la structure métallique **16,** est soumise à un rayonnement à détecter. Le champ électromagnétique incident est alors confiné entre les poutrelles **18** sur une faible épaisseur. Dans le volume ainsi défini, des paires électron-trou sont générées par l'absorption de photons par le matériau semiconducteur de la couche **12**. Périodiquement, une différence de potentiel est appliquée entre la couche **12** et les zones semiconductrices **24**. Par exemple, la couche **12** est soumise à un premier potentiel, par exemple au moyen de la structure métallique ou d'une électrode périphérique distincte en contact avec la couche **12**, et les via **26** sont soumis à un second potentiel au moyen du circuit de lecture **30**. Les porteurs de charge minoritaires diffusent alors jusqu'aux zones **24** pour leur collecte au moyen des via **26**.

On notera ainsi que les porteurs de charge diffusent vers la zone semiconductrice **24** la plus proche. De fait, il est créé des surfaces élémentaires de détection **S1-S2** (voir figure 1) autour de chaque zone **24**. Dans l'exemple illustré aux figures 1 et 2, les zones **24** sont disposées selon un réseau carré et définissent donc des surfaces élémentaires de détection carrées. Une matrice d'imagerie de 2 x 2 pixels est donc obtenue dans cet exemple.

Un exemple de procédé de fabrication d'un détecteur en CdHgTe est le suivant :
1. croissance de la couche absorbante **12** en CdHgTe sur un substrat CdZnTe par épitaxie par jets moléculaires ;
2. dépôt de la couche d'accord diélectrique **20** suivi du dépôt de la couche réflectrice **22** ;
3. création d'un contact électrique périphérique sur la couche **12** ;
4. recuit de l'ensemble pour obtenir un dopage p dans la couche en CdHgTe, par exemple entre 200°C et 300°C pendant plusieurs heures ;
5. usinage des via **26** jusque la couche en CdHgTe, ce qui induit la création des zones semiconductrices annulaires **24**, et formation des reprises de contact **28**. Les zones semiconductrices **24** peuvent également être obtenues par une étape d'implantation ionique ;
6. hybridation de l'ensemble obtenu sur le circuit **30** au moyen des billes de soudure **32** ;
7. amincissement du substrat du circuit **30** ;
8. dépôt de la couche de passivation **14** sur la couche absorbante **12** ;
9. dépôt d'une résine, **suivi** d'une insolation avec un masque présentant la topologie de la structure métallique 16 ;
10. dépôt du métal constitutif de la structure métallique **16** ; et
11. « liftoff » du métal : retrait de la résine et du métal déposé sur cette dernière.

Il est également possible dans une variante d'utiliser les reprises de contact **28** directement comme réflecteur. Dans cette configuration, les couches **22** et **28** ne forment plus qu'une seule et même couche.

Il a été décrit un mode de réalisation dans lequel les via **26** ne débouchent pas sur la face avant du photodétecteur **10**. Toutefois, l'obtention de via **26** non traversants peut être complexe, et donc couteuse, car nécessitant un contrôle très précis de la profondeur à graver dans une couche semiconductrice **12**, qui présente une épaisseur très faible. En outre, pour des raisons technologiques, liées par exemple au matériel de fabrication employé, qui impose d'hybrider le photodétecteur sur le circuit de lecture 30 avant la formation des via **26**, ces derniers peuvent être réalisés depuis la face avant du photodétecteur.

Dans une première variante, les via **26** sont isolés électriquement de la structure métalliques **16** par la couche de passivation isolante **14**. Avantageusement, la structure métallique **16** peut être partiellement, ou totalement, noyée dans la masse de la couche de passivation **14** afin d'augmenter son caractère isolant et/ou passivant.

Selon une seconde variante, dans laquelle la couche de passivation isolante **14** est absente, il convient d'éviter tout contact électrique entre la couche semiconductrice **12** et les zones semiconductrices **24** par l'intermédiaire des via **26** et de la structure métallique **16**. Pour ce faire, comme cela est illustré aux figures 3 et 4, la structure métallique **16** est éliminée autour des via **26**, avantageusement sur une surface tenant compte des incertitudes de positionnement des structures métalliques et des via inhérentes à la technologie de fabrication de ceux-ci.

Il a été décrit des modes de réalisation dans lesquelles la structure métallique prend la forme de poutrelles identiques, rectilignes, parallèles et régulièrement espacées. Cette géométrie présente cependant une sélectivité en polarisation. Notamment, la composante du rayonnement électromagnétique polarisée perpendiculairement aux poutrelles n'est que faiblement détectée. D'autres types de géométries de la structure métallique sont cependant possibles en fonction de l'application visée.

Notamment, dans un mode de réalisation illustré à la figure 5, la structure métallique présente une alternance de zones **Z1, Z2, Z3, Z4,** avec des orientations de poutrelles différentes, et avantageusement des orientations perpendiculaires pour détecter des polarisations perpendiculaires. Chaque zone **Z1, Z2, Z3, Z4**, présente en son centre une zone semiconductrice **24**.

En combinant les signaux issus de quatre pixels adjacents, il est ainsi obtenu un « macropixel » carré de 2 pixels par 2 pixels, dont le signal contient les polarisations perpendiculaires du rayonnement incident.

Une manière de combiner les signaux de plusieurs pixels afin de former un macropixel est de connecter électriquement les reprises de contact **28** de ces pixels ou de prévoir dans le circuit de lecture **30** des pistes électriques connectant en parallèle les billes de soudure **32** correspondantes. Les zones semiconductrices **24** des pixels sont alors connectées électriquement en parallèle, formant ainsi le macropixel. Le taux de remplissage optique et/ou la réponse spectrale du détecteur, ou encore la sensibilité en polarisation du détecteur sont ainsi optimisés. Cette connexion en parallèle des zones semiconductrice peut par ailleurs être permanente ou non. Par exemple, les zones semiconductrices peuvent être mises en parallèle à l'aide d'interrupteurs pilotables.

On notera, que d'autres types d'orientations sont possibles, par exemple pour détecter deux rayonnements électromagnétiques de polarisations rectilignes différentes. L'orientation des poutrelles est alors choisie en fonction de la polarisation de ces champs.

Plutôt que de détecter des polarisations différentes en combinant les signaux issus de pixels adjacents, la détection de polarisations différentes peut être obtenue directement à l'aide d'un seul pixel dont la zone semiconductrice **24** est placée au centre de la surface définie par les zones **Z1, Z2, Z3, Z4,** comme cela est illustré à la figure 6. La surface élémentaire de détection d'un pixel comprend ainsi des poutrelles d'orientations différentes, perpendiculaires dans cet exemple.

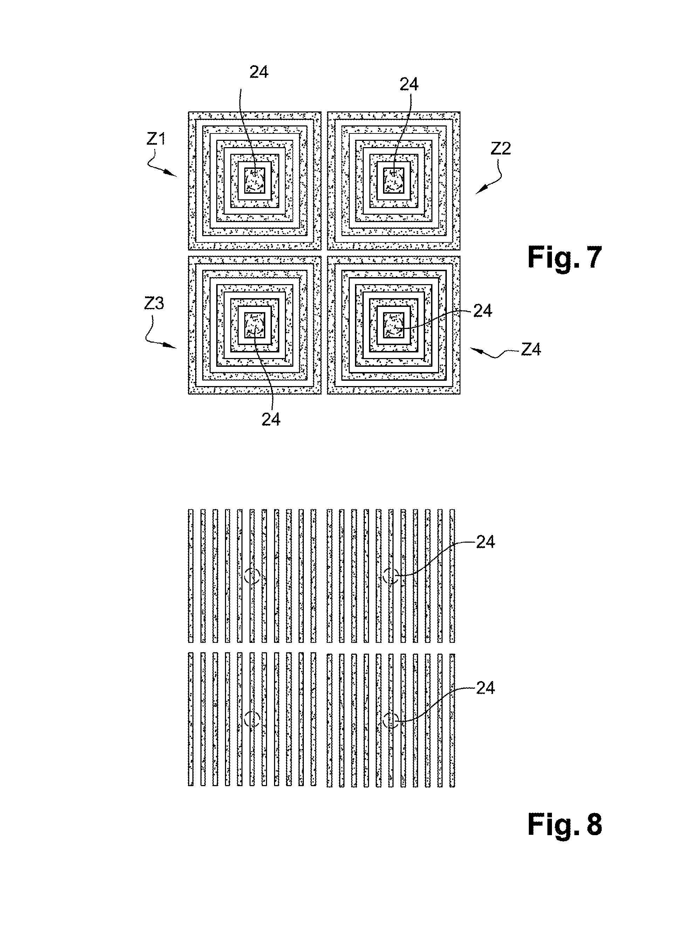

Afin de rendre la détection indépendante de la polarisation du rayonnement incident, chaque zone semiconductrice **24** est placée au centre de poutrelles formant des contours fermés concentriques, comme cela est illustré à la figure 7. Afin de maximiser le taux de remplissage du photodétecteur en pixels, les contours fermés sont avantageusement de forme carrée, bien que d'autres types de contours puissent être envisagés, comme par exemple des contours circulaires concentriques ou encore des réseaux de patchs de forme définis.

Par ailleurs, la largeur et l'espacement entre les poutrelles règlent la fréquence de résonance des plasmons de surface, et donc la fréquence à laquelle le rendement quantique du photodétecteur présente un gain élevé. Ainsi, prévoir une largeur et un espacement uniques pour la structure métallique implique une application du photodétecteur à une gamme prédéterminée de fréquences. Il peut être souhaité un photodétecteur sensible à plusieurs gammes de fréquences.

A cet effet, la structure métallique peut comporter des zones dans lesquelles les poutrelles présentent une première largeur et/ou un premier espacement en alternance avec d'autres zones où les poutrelles présentent une largeur et/ou un espacement différent afin d'obtenir une détection sensible à plusieurs gammes de fréquences. La figure 8 illustre le cas d'une détection sensible à deux gammes de fréquences, quatre pixels adjacents ayant leurs signaux combinés pour obtenir un macropixel de deux pixels sur deux pixels. On notera que l'agencement de la figure 6 avec son unique zone semiconductrice peut être également utilisé pour obtenir un pixel sensible à deux gammes de fréquences.

On notera également qu'il est possible de combiner les modes de réalisation précédents afin d'obtenir une détection selon plusieurs polarisations et plusieurs gammes de fréquences.

On notera cependant que quelle que soit la géométrie de la structure métallique, chaque zone semiconductrice **24** est avantageusement placée au barycentre géométrique de la partie de structure métallique comprise dans la surface élémentaire de détection correspondante, afin de ne pas modifier le barycentre du spectre du rayonnement incident lors de la détection.

Il a été décrit des modes de réalisation dans lesquelles la couche semiconductrice 12 est dopé p et les zones semiconductrices sont dopées n. Bien entendu, l'invention s'applique également dans le cas d'une couche semiconductrice dopée n et de zones semiconductrices **24** dopées p.

Grâce à l'invention, il est ainsi obtenu les avantages suivants :
■ un confinement du champ électromagnétique dans la couche absorbante sur un volume très limité, et par conséquent une diminution significative du courant d'obscurité, tout en disposant d'une détection bidimensionnelle du rayonnement ;
■ la possibilité d'hybrider le photodétecteur sur un circuit électronique de lecture grâce aux via débouchant sur la face arrière de celui-ci ;
■ une sélectivité en polarisation et en gammes de fréquences par un choix approprié de la structure plasmon ; et
■ un contrôle de la longueur d'onde de détection par un choix approprié de la forme et des dimensions du masque utilisé lors de la formation des structures plasmons et notamment un masque de cote variable. Ceci permet des formes différentes pour des pixels adjacents et donc des caractéristiques spectrales différentes. Une détection hyper spectrale au sein de la même couche absorbante est alors possible.

## Revendications

1. Photodétecteur comprenant :
■ une couche semiconductrice dopée (12);
■ une couche réflectrice (22), agencée sous la couche semiconductrice (12); et
■ une structure métallique (16), agencée sur la couche semiconductrice (12), et formant avec la couche semiconductrice (12) un résonateur par excitation d'un mode plasmon de surface,
***caractérisé* en ce qu'**il comprend en outre :
■ une pluralité de zones semiconductrices (24), formées dans la couche semiconductrice (12) et présentant un dopage opposé au dopage de celle-ci ; et
■ pour chaque zone semiconductrice (24), un conducteur (26) traversant le photodétecteur depuis la couche réflectrice (22) jusqu'au moins la zone semiconductrice (24), et isolé électriquement de la structure métallique (16), la zone semiconductrice (24) associée au conducteur (26) correspondant déterminant ainsi une surface élémentaire de détection du photodétecteur.

2. Photodetecteur selon la revendication 1, ***caractérisé* en ce qu'**il comporte une couche d'accord diélectrique (20), formée entre la couche réflectrice (22) et la couche semi-conductrice (12).

3. Photodétecteur selon la revendication 1 ou 2, ***caractérisé* en ce qu'**il comporte une couche isolante de passivation (14) positionnée entre la couche semiconductrice (12) et la structure métallique (16).

4. Photodétecteur selon l'une quelconque des revendications précédentes, ***caractérisé* en ce que** la zone semiconductrice (24) est sensiblement formée au barycentre géométrique de la partie de la structure métallique comprise dans la surface élémentaire de détection.

5. Photodétecteur selon l'une quelconque des revendications précédentes, ***caractérisé* en ce que** la partie de la structure métallique (16) comprise dans la surface élémentaire de détection comporte des zones de motifs parallèles d'orientations différentes, notamment des zones de motifs d'orientations sensiblement perpendiculaires les unes par rapport aux autres.

6. Photodétecteur selon l'une quelconque des revendications 1 à 4, ***caractérisé* en ce que** la structure métallique comporte un réseau de patchs métalliques ou un réseau de trous formés dans un film métallique.

7. Photodétecteur selon l'une quelconque des revendications 1 à 4, ***caractérisé* en ce que** la partie de structure métallique (16) comprise dans la surface élémentaire de détection comporte des éléments longilignes formant des contours fermés concentriques, notamment des contours sensiblement de forme carrée ou circulaire.

8. Photodétecteur selon l'une quelconque des revendications 1 à 4, ***caractérisé* en ce que** la partie de structure métallique (16) comprise dans une surface élémentaire de détection comporte des motifs parallèles, l'orientation des motifs d'une surface élémentaire de détection étant différente de l'orientation des motifs d'une surface de détection adjacente, et notamment perpendiculaire.

9. Photodétecteur selon l'une quelconque des revendications 1 à 4, ***caractérisé* en ce que** la partie de structure métallique (16) comprise dans une surface élémentaire de détection comporte des motifs parallèles, la périodicité spatiale des motifs d'une surface élémentaire de détection étant différente de la périodicité spatiale des motifs d'une zone élémentaire de détection adjacente.

10. Photodétecteur selon l'une quelconque des revendications précédentes, ***caractérisé* en ce que** les zones élémentaires de détection sont regroupées en macropixels, les zones semiconductrices de chaque macropixel étant aptes à être connectées électriquement en parallèle.

11. Photodétecteur selon la revendication 10, ***caractérisé* en ce que** les surfaces élémentaires de détection d'un macropixel comportent des zones de motifs parallèles d'orientations différentes, notamment des zones de motifs d'orientations sensiblement perpendiculaires les unes par rapport aux autres.

12. Photodétecteur selon la revendication 10, ***caractérisé* en ce que** les surfaces élémentaires de détection d'un macropixel comportent des motifs parallèles, l'orientation des motifs d'une surface élémentaire de détection étant différente de l'orientation des motifs d'une surface de détection adjacente, et notamment perpendiculaire.

13. Photodétecteur selon l'une quelconque des revendications précédentes, ***caractérisé* en ce que** le conducteur (26) comporte, du côté de la couche réflectrice (22), une surface de reprise de contact (28) pour l'hybridation du photodétecteur sur un circuit électronique (30).

14. Photodétecteur selon la revendication 13, ***caractérisé* en ce que** la couche réflectrice (22) et la surface de reprise de contact (28) ne forment qu'une seule et même couche.

15. Photodétecteur selon l'une quelconque des revendications précédentes, ***caractérisé* en ce que** la couche semiconductrice (12) et les zones semiconductrices (24) sont constituées de CdHgTe ou CdZnTe.
